# EUROPEAN PATENT SPECIFICATION

(11) **EP 0 710 001 B1**
(45) Date of publication and mention of the grant of the patent: **17.03.1999**
(21) Application number: 94830521.4
(22) Date of filing: 31.10.1994
(51) Int. Cl.: H04N 1/00, G06T 5/20

(54) **A fuzzy logic filter for images with impulse noise**
Fuzzy-Logikfilter für Bilder mit Impulsrauschen
Filtre en logique floue pour des images dans du bruit d'impulsions

(43) Date of publication of application: 01.05.1996
(73) Proprietor: STMicroelectronics S.r.l., 20041 Agrate Brianza (Milano) (IT)
(72) Inventor: Pennino, Laura, I-34100 Trieste (IT); Poluzzi, Rinaldo, I-20100 Milano (IT); Mancuso, Massimo, I-92026 Favara (Agrigento) (IT); Rizzotto, Gianguido, I-22040 Civate (Como) (IT); Travaglia, Federico, I-20100 Milano (IT)
(74) Representative: Botti, Mario

(56) References cited:
- EP-A- 0 415 648
- US-A- 5 245 445
- PATENT ABSTRACTS OF JAPAN vol. 17, no. 445 (P-1539) 16 August 1993 & JP-A-05 094 523 (YOKOGAWA MEDICAL SYST LTD) 16 April 1993
- PATENT ABSTRACTS OF JAPAN vol. 17, no. 427 (E-1413) 12 August 1993 & JP-A-05 091 532 (TOSHIBA CORP) 9 April 1993

## Description

The present invention relates to an electronic device used in video applications and specifically to a filter performing on video images a reduction of the pulsed noise in accordance with fuzzy logic.

The present invention also relates to a method for performing on video images a reduction of the pulsed noise in accordance with fuzzy logic.

As is known, in the field of television signal processing a very serious problem is generally that of reducing the effects caused by the presence of noise without reducing the signal part containing useful data.

A typical noise present in video signals is the pulsed noise. Its effects are such as to change the grey level of a so-called image pixel so as to cause a peak of luminosity (positive or negative) to appear in a nearly homogeneous image region.

The presence of the pulsed noise causes nearly white or nearly black dots in the image which in the sequence of moving images cause a so-called snowy effect.

In the scientific literature there are many examples of filters using fuzzy logic to perform a selection among the signal parts containing useful data and the signal part containing noise so as to filter out only the latter.

The fuzzy procedures used by these filters are described for example in the articles "Fuzzy Operators for Sharpening of Noisy Images" by F. Russo and G. Ramponi in Electronics Letters Vol. 28 No. 18, August 1992, and "Working on Image Data Using Fuzzy Rules" by F. Russo and G. Ramponi in Signal Processing IV Theories and Applications, Proceedings of EUSIPCO-92, Brussels, Belgium August 1992.

Although advantageous in some ways these filters exhibit very complex architectures.

The technical problem underlying the present invention is to provide a filter and associated filtering method for performing a reduction of the pulsed noise contained in video images in accordance with fuzzy logic which would be structurally very simple while achieving high quality of the filtered image.

The technical problem is solved by a filter performing in accordance with fuzzy logic a reduction of the pulsed noise on video images of the type indicated above and defined in claims 1 and following.

The problem is also solved by a filtering method of the type indicated above and defined in claims 7 and following.

The characteristics and advantages of the filter in accordance with the present invention and the associated filtering method are set forth in the description of an embodiment thereof given below by way of non-limiting example with reference to the annexed drawings.

In the drawings:
FIG. 1 shows a schematic view of a filter in accordance with the present invention;
FIG. 2 shows a schematic view of a detail of the filter of FIG. 1;
FIG. 2a shows schematically a so-called working window of the filter in accordance with the present invention; and
FIG. 3 shows a schematic view of another detail of the filter of FIG. 1.

With reference to those figures, the number 1 indicates schematically as a whole a filter provided in accordance with the present invention to secure reduction of the pulsed noise on video images and in accordance with a fuzzy logic procedure.

It is well to clarify that hereinafter image field is defined as a group of lines constituting a video image in the same time interval.

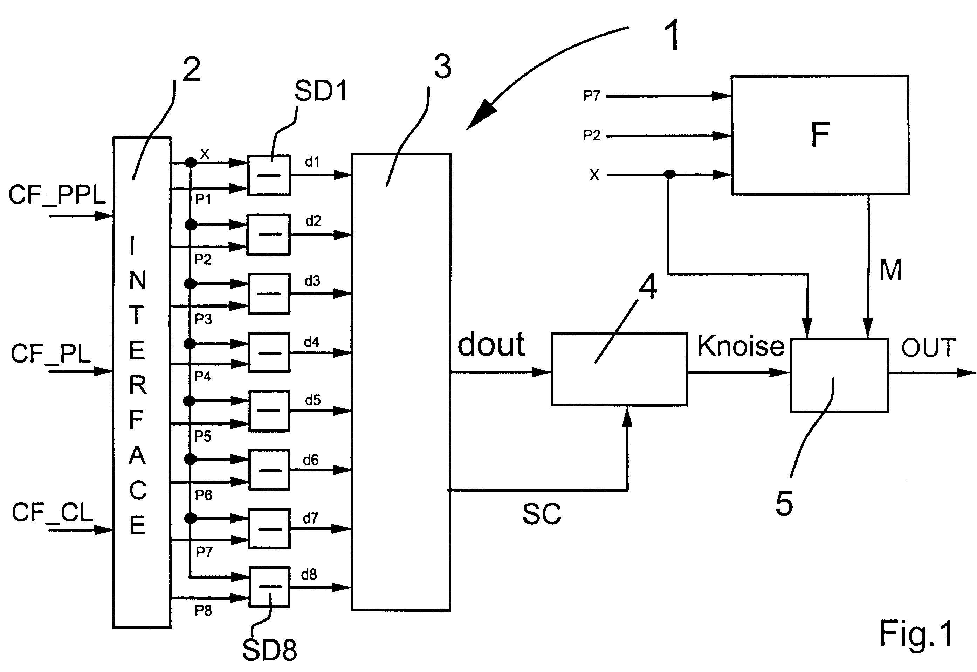

As shown in FIG. 1 the filter 1 has at least three input terminals designed to receive digital signals for image lines consecutive in time CF_PPL, CF_PL, CF_CL of a current image field.

In FIG. 1 it is also seen that the filter 1 comprises an interface circuit 2 having a first, a second and a third input terminal coinciding with the input terminals of the filter 1, and a plurality of output terminals.

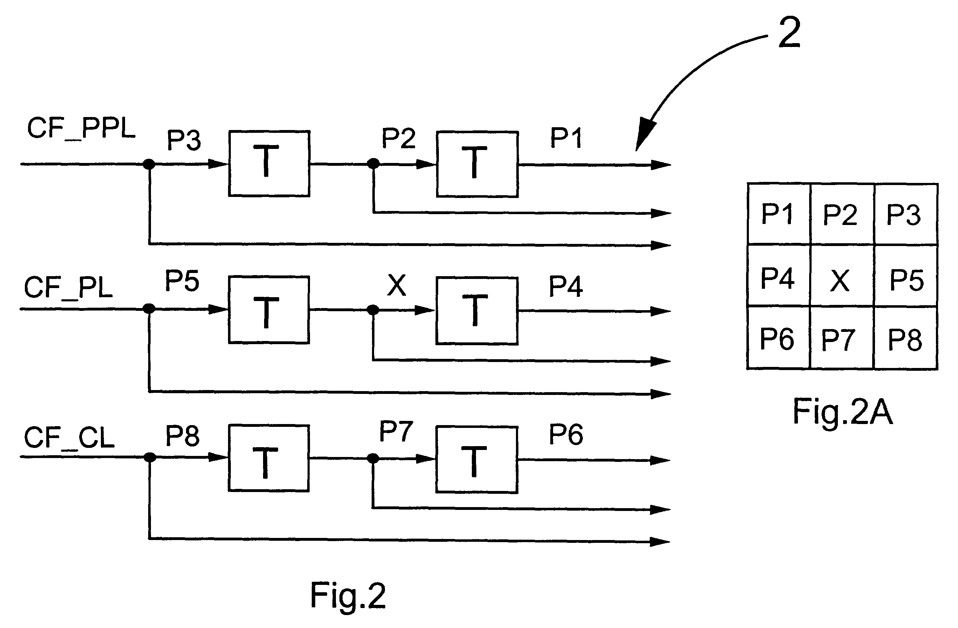

FIG. 2 shows in greater detail the internal structure of the interface circuit 2.

It comprises a plurality of delay blocks T which allow delaying appropriately the digital signals present at the inputs of the filter 1 so as to create a working window or image window shown in FIG. 2A.

Specifically this window comprises nine digital signals. The digital signals included in the central line belong to the image line CF_PL while the digital signals included in the first and last lines belong to the image lines CF_PPL and CF_CL. The digital signal X in which the work signal is centred is the signal to be processed.

FIG. 1 also shows that the filter 1 comprises a plurality of digital subtractors SDi, e.g. with i=1,...8, each having a first and a second input terminal and an output terminal.

The first input terminals of the digital subtractors SDi are designed to receive the digital signal X to be processed while each of the second input terminals of said subtractors receives one of the remaining digital signals included in the image window.

Output from the digital subtractors SDi are a plurality of difference signals di, with i=1,...,8. It is well to note that each of the digital signals included in the image window is representative of the grey level associated with a so-called image pixel.

Consequently each of the signals di represent the difference between the grey level associated with the image pixel to be processed and the grey level associated with an image pixel adjacent thereto.

A pixel is considered affected by pulsed noise if its grey level is totally different from the grey level of the pixels adjacent thereto.

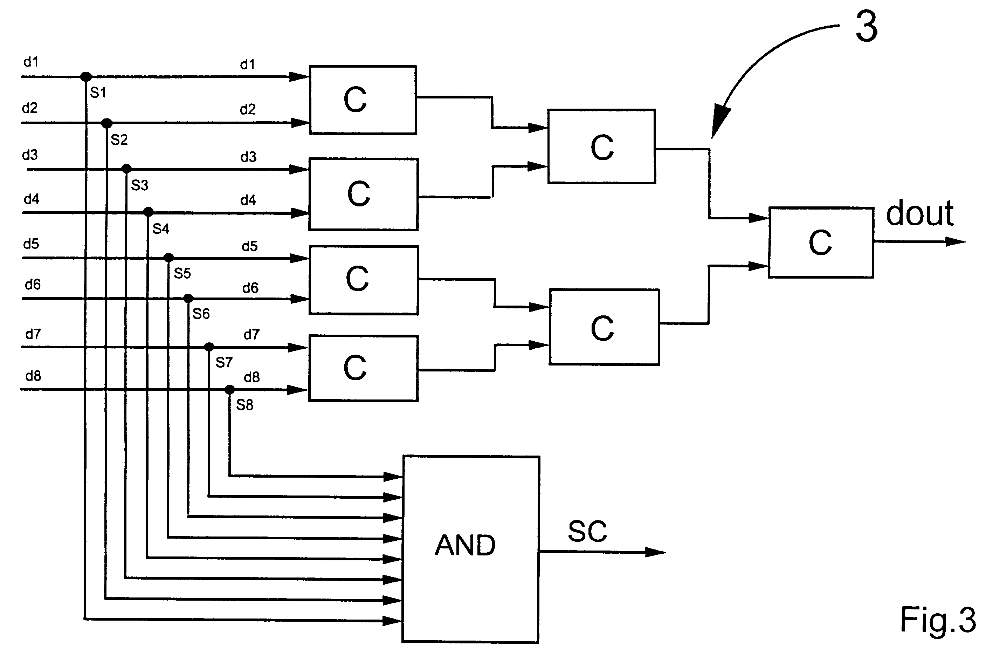

Again with reference to FIG. 1 it can be observed that the filter 1 also comprises a comparator block 3 whose internal structure is shown in FIG. 3 which has a plurality of input terminals designed to receive the difference signals di and a first and a second output terminal.

This comparator block 3 is designed to perform on said difference signals di subsequent comparisons by means of a plurality of comparator sub-blocks C connected together in cascade.

In this manner the first output terminal of block 3 receives a difference signal dout coinciding with that between the difference signals di which has minimum modulus value.

It is also necessary to specify that the difference signals di are coded with six bits of which the most (or least) significant represents the sign. As shown in FIG. 3 the sign bits, indicated by Si, with i=1,...,8, are sent to a plurality of inputs of a logic circuit L also incorporated in the comparator block 3.

Said logic circuit L is provided essentially through an AND logic port with eight inputs and is designed to generate a control signal SC which is received from the second output terminal of block 3. The signal SC can assume the logic values 0 or 1.

Again with reference to FIG. 1 the filter 1 comprises a memory circuit 4 having a first input terminal connected to the first output terminal dout of the comparator block 3 and of an output terminal.

The circuit 4 also has an enablement input designed to receive the control signal SC present at the output of the logic circuit L.

It is well to note that if the control signal SC assumes value 0, i.e. the difference signals di do not all exhibit the same sign, the pixel being processed is surely not affected by pulsed noise because its grey level is not totally different from the grey levels of the adjacent pixels.

In this case the pixel being processed is not filtered.

Contrariwise if the control signal SC assumes value 1 the pixel being processed may or may not be affected by pulsed noise.

Naturally if said pixel is affected by pulsed noise it must be filtered.

The memory circuit 4 comprises a plurality of memory elements addressed through the value of dout and designed for memorising the results achieved by executing off-line a fuzzy procedure, which is described below, to appraise in what measure the pixel being processed is affected or not by pulsed noise. Said results represent the values, inside the interval [0,1], taken on by a Knoise parameter which is representative of the quantity of pulsed noise present in the pixel being processed.

It is well to note that based on the type of noised considered the memory elements included in the circuit 4 can be very small.

The structure of the filter 1 also comprises an arithmetic block 5 having a first, a second and a third input terminal and an output terminal coinciding with an output terminal of the filter 1.

There is also provided a filtering circuit F having a first, a second and a third input terminal and an output terminal.

Specifically the first input terminal of the arithmetic block 5 is connected to the output terminal of the memory circuit 4 while the second and third input terminals of said block are connected to the third input terminal and the output terminal respectively of the filtering circuit F.

The input terminals of the circuit F are connected to output terminals of the interface circuit 2 so as to receive the digital signals P7, P2 and X respectively situated along a column of the image window.

The filtering circuit F whose embodiment calls for the employment of a vertical median filter with three points of the conventional type is designed to organize the values of the signals present at its inputs and supply at output a value indicated by M.

The arithmetic block 5 is designed to implement the following formula:$\text{OUT = Knoise * M + (1-Knoise)* X}$

It is found therefrom that if the Knoise parameter assumes the value 0 in the pixel being processed the presence of pulsed noise is not detected and hence the digital signal X representing the grey level associated with said pixel remains unchanged at the output of the filter 1.

But if the Knoise parameter takes a value other than 0 in the pixel being processed is detected the present of pulsed noise and hence the output of the filter 1 is represented by the signal OUT obtained from the formula (1).

In particular if Knoise is equal to 1 the output of the filter 1 coincides with the output of the filtering circuit F.

There is now described the filtering method in accordance with the present invention with reference to an initial state in which the digital signals for the consecutive image lines CF_PPL, CF_PL, CF_CL of the current image field are presented at the input of the interface 2. The filtering method is essentially structured in accordance with two successive steps.

In the first step is detected by means of fuzzy logic procedures a Knoise parameter value.

In the second step on the basis of the value of this parameter the filter 1 through the formula (1) implemented by the arithmetic block 5 performs a soft switch between the original digital signal X representing the grey level associated with the pixel being processed and the output M of the filtering circuit F.

As mentioned above detection of the pulsed noise is performed by making use of a simulated off-line fuzzy procedure.

Specifically said procedure is based on at least two so-called fuzzy logic inference rules of the type:
1) IF d1 is High Positive AND d2 is High Positive AND ... AND d8 is High Positive THEN Knoise is High ELSE is Low,
2) IF d1 is High Negative AND d2 is High Negative AND... AND d8 is High Negative THEN Knoise is HIGH ELSE is Low.

As may be seen the antecedent part IF of each rule includes at least eight antecedent prepositions each represented by a difference signal di calculated through the digital subtractors SDi.

By stating the antecedent part of the rules this way all the data acquired from the digital signals included in the image window of FIG. 2A are considered in a single step of the fuzzy calculation.

Calculation of the antecedent part of the fuzzy rules through the comparator block 3 produces as a result a value for the digital signal dout.

This value is used for calculation of the consequent part of the fuzzy rules from which is obtained the corresponding value for the Knoise parameter. Modifications and changes can be made to the architecture and method in accordance with the present invention all however falling within the scope of the following claims.

## Claims

1. Filter for performing a reduction of pulsed noise on video images in accordance with fuzzy logic, comprising:
- at least one interface circuit (2) receiving as input digital signals consecutive in time and corresponding to said video images and designed to generate an image window centred in a digital signal (X) to be processed,
- at least one comparator block (3) having a plurality of input terminals coupled with output terminals of the interface circuit (2) through a plurality of digital subtractors (SDi),
- at least one memory circuit (4) connected in cascade with the comparator block (3) and comprising a plurality of memory elements designed to store values of a parameter (Knoise) obtained from a procedure performed by fuzzy logic procedures on the basis of outputs of the comparator block (3),
- at least one filtering circuit (F) having inputs connected to some outputs of the interface circuit (2) and designed to organize the values of said inputs,
- at least one arithmetic block (5) having a first input terminal connected to an output terminal of the memory circuit (4) and a second input terminal designed to receive the digital signal (X) to be processed and a third input terminal connected to an output terminal of the filtering circuit (F) and said arithmetic block (5) being designed to perform a switch between the digital signal (X) to be processed and the output of the filtering circuit (F) on the basis of the values taken by the parameter (Knoise).

2. Filter in accordance with claim 1 characterised in that the comparator block (3) comprises a plurality of comparator sub-blocks (C) of which some are connected at output to the digital subtractors (SDi) and the remaining ones connected together in cascade and which are designed to perform subsequent comparisons on difference signals (di), calculated by the digital subtractors (SDi), to generate a difference signal (dout) having minimal modulus.

3. Filter in accordance with claim 2 characterised in that the comparator block (3) comprises a logic block (L) having a plurality of input terminals each connected to the output of a corresponding digital subtractor (SDi) to receive digital signals (Si) representing the sign bit of the difference signals (di) and said logic block (L) being designed to generate a control signal (SC).

4. Filter in accordance with claim 3 characterised in that said control signal (SC) is received by an enablement input of the memory circuit (4).

5. Filter in accordance with claim 3 characterised in that said logic block (L) is provided through an AND logical gate.

6. Filter in accordance with claim 4 characterised in that the plurality of memory elements included in the memory circuit (4) are addressed through the digital signal (dout) output from the comparator block (3).

7. Method of filtering the pulsed noise present in video images for which is defined an image window centred in a digital signal (X) to be processed through an interface circuit (2) and said digital signal (X) to be processed being filtered in a filtering circuit (F), comprising at least the steps of
- detecting on the basis of fuzzy logic procedures parameter values (Knoise) for use in an interpolation arithmetic block (5), and
- switching on the basis of the values of the parameter (Knoise) between a digital signal (X) to be processed and the output of the filtering circuit (F).

8. Method in accordance with claim 7 characterised in that the detecting step comprises a comparison between the digital signal (X) to be processed and other digital signals included in the image window obtained by means of the interface circuit (2).

9. Method in accordance with claim 8 characterised in that said comparison is performed through a comparator block (3) having a plurality of input terminals coupled with output terminals of the interface circuit (2) through a plurality of subtractors (Sdi).

## Patentansprüche

1. Filter zum Reduzieren von Impulsrauschen bei Videobildern gemäß Fuzzylogik, umfassend:
- mindestens eine Schnittstellenschaltung (2), die als Eingabe digitale, zeitlich sequentielle Signale empfängt, die den Videobildern entsprechen, ausgebildet zum Erzeugen eines Bildfensters, welches in einem zu verarbeitenden digitalen Signal (X) zentriert ist,
- mindestens einen Vergleicherblock (3) mit mehreren Eingangsanschlüssen, die an Ausgangsanschlüsse der Schnittstellenschaltung (2) über mehrere digitale Subtrahierer (SDi) gekoppelt sind,
- mindestens einen Speicherblock (4), der in Kaskade zu dem Vergleicherblock (3) geschaltet ist und mehrere Speicherelemente aufweist, ausgebildet zur Speicherung von Werten eines Parameters (Knoise), der aus einer Prozedur erhalten wurde, die durch Fuzzylogik-Prozeduren auf der Grundlage der Ausgangssignale des Vergleicherblocks (3) durchgeführt werden,
- mindestens eine Filterschaltung (F) mit Eingängen, die an einige Ausgänge der Schnittstellenschaltung (2) angeschlossen sind und so ausgelegt, daß sie die Werte der Eingangsgrößen organisieren,
- mindestens einen arithmetischen Block (5), der mit einem ersten Eingangsanschluß an einen Ausgangsanschluß der Speicherschaltung (4) angeschlossen ist, und von dem ein zweiter Eingangsanschluß zum Empfangen des zu verarbeitenden digitalen Signals (X) ausgebildet ist, wobei ein dritter Eingangsanschluß an einen Ausgangsanschluß der Filterschaltung (F) angeschlossen ist, und der Arithmetikblock (5) dazu ausgebildet ist, eine Umschaltung vorzunehmen zwischen dem zu verarbeitenden digitalen Signal (X) und dem Ausgang der Filterschaltung (F), abhängig von den von den Paramter (Knoise) angenommenen Werten.

2. Filter nach Anspruch 1,
**dadurch gekennzeichnet,**
daß der Vergleicherblock (3) mehrere Vergleicher-Teilblöcke (C) aufweist, von denen einige an den Ausgang der digitalen Subtrahierer (SDi) angeschlossen und die übrigen in Kaskade zusammengeschaltet sind und so ausgebildet sind, daß sie nachfolgende Vergleiche von Differenzsignalen (Di) durchführen, die von den digitalen Subtrahierern (SDi) berechnet wurden, um ein Differenzsignal (dout) mit kleinstem Betrag zu erzeugen.

3. Filter nach Anspruch 2,
**dadurch gekennzeichnet,**
daß der Vergleicherblock (3) einen Logikblock (L) mit mehreren Eingangsanschlüssen aufweist, von denen jeder an den Ausgang eines entsprechenden digitalen Subtrahierers (SDi) angeschlossen ist, um digitale Signale (Si) zu empfangen, die das Vorzeichenbit der Differenzsignale (Di) darstellen, wobei der Logikblock (L) zum Erzeugen eines Steuersignals (SC) ausgebildet ist.

4. Filter nach Anspruch 3,
**dadurch gekennzeichnet,**
daß das Steuersignal (SC) von einem Freigabeeingang der Speicherschaltung (4) empfangen wird.

5. Filter nach Anspruch 3,
**dadurch gekennzeichnet,**
daß der Logikblock (L) durch ein logisches UND-Gatter gebildet wird.

6. Filter nach Anspruch 4,
**dadurch gekennzeichnet,**
daß die Speicherelemente in der Speicherschaltung (4) über das digitale Signal (dout), welches von dem Vergleicherblock (3) abgegeben wird, adressiert werden.

7. Verfahren zum Filtern des Impulsrauschens in Videobildern, für die über eine Schnittstellenschaltung (2) ein in einem zu verarbeitenden digitalen Signal (X) zentriertes Bildfenster definiert ist und das zu verarbeitende digitale Signal (X) in einer Filterschaltung (F) gefiltert wird, umfassend mindestens folgende Schritte:
auf der Grundlage von Fuzzylogik-Prozeduren werden Parameterwerte (Knoise) erfaßt, die in einem Interpolations-Arithmetikblock (5) verwendet werden, und
es erfolgt auf der Grundlage der Werte des Parameters (Knoise) eine Umschaltung zwischen einem digitalen, zu verarbeitenden Signal (X) und dem Ausgang der Filterschaltung (F).

8. Verfahren nach Anspruch 7,
**dadurch gekennzeichnet,**
daß das Erfassen einen Vergleich zwischen dem zu verarbeitenden Digitalsignal (X) und weiteren digitalen Signalen beinhaltet, die in dem mit Hilfe der Schnittstellenschaltung (2) erhaltenen Bildfenster enthalten sind.

9. Verfahren nach Anspruch 8,
**dadurch gekennzeichnet,**
daß der Vergleich mit Hilfe eines Vergleicherblocks (3) durchgeführt wird, der mehrere Eingangsanschlüsse aufweist, die an Ausgangsanschlüsse der Schnittstellenschaltung (2) über eine Mehrzahl von Subtrahierern (SDi) angeschlossen sind.

## Revendications

1. Filtre à logique floue pour effectuer une réduction de bruit impulsionnel sur des images vidéo, comprenant:
- au moins un circuit d'interface (2) recevant en entrée des signaux numériques consécutifs dans le temps et correspondant auxdites images vidéo et servant à générer une fenêtre d'image centrée sur un signal numérique (X) à traiter,
- au moins un bloc comparateur (3) ayant une pluralité de bornes d'entrée couplées avec des bornes de sortie du circuit d'interface (2) par l'intermédiaire d'une pluralité de soustracteurs (SDi),
- au moins un circuit de mémoire (4) connecté en cascade avec le bloc comparateur (3) et comprenant une pluralité d'éléments mémoire servant à stocker des valeurs d'un paramètre (Knoise) obtenu par une procédure effectuée au moyen de procédures de logique floue sur la base des sorties du bloc comparateur (3),
- au moins un circuit de filtrage (F) ayant des entrées connectées à quelques sorties du circuit d'interface (2) et servant à organiser les valeurs desdites entrées,
- au moins un bloc arithmétique (5) ayant une première borne d'entrée connectée à une borne de sortie du circuit mémoire (4) et une seconde borne d'entrée servant à recevoir le signal numérique (X) à traiter et une troisième entrée connectée à une borne de sortie du circuit de filtrage (F) et ledit bloc arithmétique (5) étant destiné à effectuer une commutation entre le signal numérique (X) à traiter et la sortie du circuit de filtrage (F) sur la base des valeurs prises par le paramètre (Knoise).

2. Filtre selon la revendication 1 caractérisé en ce que le bloc comparateur (3) comprend une pluralité de sous-blocs comparateurs (C) dont quelques uns sont connectés en sortie aux soustracteurs numériques (SDi) et le reste sont connectés ensemble en cascade et qui servent à effectuer des comparaisons ultérieures sur des signaux différentiels (di), calculés par les soustracteurs numériques (SDi), pour générer un signal différentiel (dout) ayant une amplitude minimale.

3. Filtre selon la revendication 2 caractérisé en ce que le bloc comparateur (3) comprend un bloc logique (L) ayant une pluralité de bornes d'entrée chacune connectée à la sortie d'un soustracteur numérique (SDi) correspondant pour recevoir des signaux numériques (Si) représentant le bit de signe des signaux différentiels (di) et ledit bloc logique (L) étant destiné à générer un signal de commande (SC).

4. Filtre selon la revendication 3 caractérisé en ce que ledit signal de commande (SC) est reçu par une entrée de mise en service du circuit mémoire (4).

5. Filtre selon la revendication 3 caractérisé en ce que ledit bloc logique (L) est obtenue au moyen d'une porte logique ET.

6. Filtre selon la revendication 4 caractérisé en ce que la pluralité d'éléments mémoire contenus dans le circuit mémoire (4) sont adressés par le signal numérique (dout) délivré en sortie par le bloc comparateur (3).

7. Procédé de filtrage du bruit impulsionnel présent dans les images vidéo pour lequel est définie une fenêtre d'image centrée sur un signal numérique (X) à traiter par un circuit d'interface (2) et ledit signal numérique (X) à traiter étant filtré dans un circuit de filtrage (F) comprenant au moins les étapes suivantes:
- détecter sur la base de procédures de logique floue des valeurs de paramètre (Knoise) destinées à être utilisées dans un bloc arithmétique d'interpolation (5), et
- commuter sur la base des valeurs du paramètre (Knoise) entre un signal numérique (X) à traiter et la sortie du circuit de filtrage (F).

8. Procédé selon la revendication 7 caractérisé en ce que l'étape de détection comprend une comparaison entre un signal numérique (X) à traiter et d'autres signaux numériques contenus dans la fenêtre d'image obtenue au moyen du circuit d'interface (2).

9. Procédé selon la revendication 8, caractérisé en ce que ladite comparaison est effectuée par un bloc comparateur (3) ayant une pluralité de bornes d'entrée couplées avec des bornes de sortie du circuit d'interface (2) par l'intermédiaire d'une pluralité de soustracteurs (SDi).
